# EUROPEAN PATENT APPLICATION

(11) **EP 3 542 952 A1**
(43) Date of publication of application: **25.09.2019**
(21) Application number: 17872636.0
(22) Date of filing: 07.08.2017
(51) Int. Cl.: B23Q 11/00, B23B 27/14, B23B 27/20, B23C 3/00, B23C 5/16, B23Q 11/10, B23Q 17/00, B23Q 17/10, C01B 32/25, C23C 16/27, C30B 29/04

(54) **METHOD FOR MACHINING MATERIAL TO BE MACHINED, MACHINE TOOL, AND METHOD FOR MANUFACTURING MEMBER, BY USING DIAMOND TOOL EQUIPPED WITH NANO POLYCRYSTALLINE DIAMOND OR VAPOR-PHASE SYNTHESIZED MONOCRYSTAL DIAMOND**

(30) Priority: 16.11.2016 JP 2016223262
(71) Applicant: Sumitomo Electric Hardmetal Corp., Itami-shi, Hyogo 664-0016 (JP); Sumitomo Electric Industries, Ltd., Osaka-shi, Osaka 541-0041 (JP)
(72) Inventor: UEDA, Akihiko, Itami-shi Hyogo 664-0016 (JP); ABE, Machiko, Itami-shi Hyogo 664-0016 (JP); KOBAYASHI, Yutaka, Itami-shi Hyogo 664-0016 (JP); KUKINO, Satoru, Itami-shi Hyogo 664-0016 (JP); HARADA, Takashi, Itami-shi Hyogo 664-0016 (JP)
(74) Representative: Boult Wade Tennant LLP
(86) International application number: PCT/JP2017/028534
(87) International publication number: WO 2018/092364

(57) **Abstract**

A method for processing a workpiece by using a diamond tool comprising nano-polycrystalline diamond or vapor-phase synthesized single crystal diamond, the nano-polycrystalline diamond comprising 10 ppm or more and 1000 ppm or less of nitrogen atoms, the vapor-phase synthesized single crystal diamond comprising 1 ppm or more and 100 ppm or less of nitrogen atoms, in processing the workpiece, the diamond tool having a temperature of 400°C or lower at a contact point of the workpiece and the diamond tool, a spatial region within a distance of 3 cm from the contact point having an oxygen concentration of 20% or less.

## Description

### TECHNICAL FIELD

The present invention relates to a method for processing a workpiece by using a diamond tool comprising nano-polycrystalline diamond or vapor-phase synthesized single crystal diamond. The subject application claims priority based on Japanese Patent Application No. 2016-223262 filed on November 16, 2016. All the contents described in the Japanese patent application are incorporated herein by reference.

### BACKGROUND ART

Diamond has many excellent properties such as high hardness, high thermal conductivity, high optical transmittance and wide band gap, and is accordingly, widely used as a material for various tools, optical components, semiconductors, and electronic components. In particular, cutting tools and wear-resistant tools making use of having high hardness are major industrial applications of diamond, and it is believed that the importance of diamond will further be increased in the future.

Industrially widely used diamonds are naturally produced diamonds as well as single crystal diamonds produced through high-temperature and high-pressure synthesis and being stable in quality, sintered materials of diamond containing a binder such as iron, cobalt and nickel, and the like. Furthermore, in recent years, as artificial synthesis technology has advanced, nano-polycrystalline diamond synthesized with ultrahigh pressure and ultrahigh temperature applied (for example, see Sumiya et al., "Cutting Performance of Nano-polycrystalline Diamond," July 2010, SEI Technical Review, No. 177, page 107 (NPL 1)), a large-size vapor-phase synthesized single crystal diamond synthesized through vapor deposition (for example, see Japanese Patent Laying-Open No. 2012-111653 (PTL 1)), and the like are increasingly used.

Nano-polycrystalline diamond is a strong polycrystal composed of single-phase diamond containing no binder and has a structure in which ultrafine diamond grains of about several tens nanometers directly and firmly bond to each other. Such a nano-polycrystalline diamond has excellent hardness exceeding that of a single crystal and has no cleavability or crystalline anisotropy, and accordingly, has an excellent mechanical property. A tool comprising such nano-polycrystalline diamond can implement a cutting and thus finishing process for cemented carbide, ceramic, and other hard brittle materials which have conventionally been difficult to cut and thus finish.

Large-size vapor-phase synthesized single crystal diamond is prepared by disposing a single crystal diamond seed substrates without a gap to form an underlying substrate, synthesizing a seamless vapor-phase synthesized single crystal diamond thereon by homoepitaxial growth, and thereafter separating the underlying substrate. The large-size vapor-phase synthesized single crystal diamond thus produced can have a size which has conventionally been difficult to obtain. A tool comprising such a large-size vapor-phase synthesized single crystal diamond allows a significant reduction of a tact time in processing an acrylic end face in one step to have a mirror finished surface, milling an aluminum alloy, and the like.

### CITATION LIST

### PATENT LITERATURE

PTL 1: Japanese Patent Laying-Open No. 2012-111653

### NON PATENT LITERATURE

NPL 1: Sumiya et al., "Cutting Performance of Nano-polycrystalline Diamond," July 2010, SEI Technical Review, No. 177, page 107

### SUMMARY OF INVENTION

A method for processing a workpiece by using a diamond tool comprising nano-polycrystalline diamond or vapor-phase synthesized single crystal diamond according to one aspect of the present disclosure is such that the nano-polycrystalline diamond comprises 10 ppm or more and 1000 ppm or less of nitrogen atoms and the vapor-phase synthesized single crystal diamond comprises 1 ppm or more and 100 ppm or less of nitrogen atoms, and in processing a workpiece the diamond tool has a temperature of 400°C or lower at a contact point of the workpiece and the diamond tool and a spatial region within a distance of 3 cm from the contact point has an oxygen concentration of 20% or less.

A machine tool according to one aspect of the present disclosure comprises: a processing chamber capable of accommodating a workpiece therein; a diamond tool disposed inside the processing chamber; a thermometer for measuring the temperature of a contact point of the workpiece accommodated in the processing chamber and the diamond tool; and an oxygen concentration meter for measuring an oxygen concentration at the contact point, the diamond tool comprising nano-polycrystalline diamond or vapor-phase synthesized single crystal diamond, the nano-polycrystalline diamond comprising 10 ppm or more and 1000 ppm or less of nitrogen atoms, the vapor-phase synthesized single crystal diamond comprising 1 ppm or more and 100 ppm or less of nitrogen atoms, the oxygen concentration meter being disposed at a position within 3 cm from the contact point, in processing the workpiece, a temperature, as measured by the thermometer, being controlled to 400°C or lower, an oxygen concentration, as measured by the oxygen concentration meter, being also controlled to have a value of 20% or less.

A method for manufacturing a member by processing a workpiece by using a diamond tool comprising nano-polycrystalline diamond or vapor-phase synthesized single crystal diamond according to one aspect of the present disclosure is such that the nano-polycrystalline diamond comprises 10 ppm or more and 1000 ppm or less of nitrogen atoms and the vapor-phase synthesized single crystal diamond comprises 1 ppm or more and 100 ppm or less of nitrogen atoms, and in processing the workpiece the diamond tool has a temperature of 400°C or lower at a contact point of the workpiece and the diamond tool and a spatial region within a distance of 3 cm from the contact point has an oxygen concentration of 20% or less.

### BRIEF DESCRIPTION OF DRAWINGS

Fig. 1 is a schematic diagram for illustrating a method for processing a workpiece, a machine tool, and a method for manufacturing a member, by using a diamond tool according to one embodiment.
Fig. 2 is a schematic diagram for illustrating a method for processing a workpiece, a machine tool, and a method for manufacturing a member, by using a diamond tool according to another embodiment.

### DETAILED DESCRIPTION

### [Problem to be Solved by the Present Disclosure]

However, the above nano-polycrystalline diamond and vapor-phase synthesized single crystal diamond are per se difficult to produce, and there is a tendency that it is difficult to process and thus shape them to apply them to tools. For this reason, they are still more expensive than conventional products, and accordingly, it is actually difficult to replace conventional diamond tools with them. That is, it has been often the case that a diamond tool comprising nano-polycrystalline diamond or vapor-phase synthesized single crystal diamond is poor in cost performance and accordingly, limited in application.

The present disclosure contemplates a method for processing a workpiece, a machine tool, and a method for manufacturing a member, that present excellent cost performance by using a diamond tool comprising nano-polycrystalline diamond or vapor-phase synthesized single crystal diamond.

### [Advantageous Effect of the Present Disclosure]

According to the above, there can be provided a method for processing a workpiece, a machine tool, and a method for manufacturing a member, that present excellent cost performance by using a diamond tool comprising nano-polycrystalline diamond or vapor-phase synthesized single crystal diamond.

### [Description of Embodiments]

The present inventors have diligently studied to suppress wear of a cutting edge of a diamond tool comprising nano-polycrystalline diamond or vapor-phase synthesized single crystal diamond (hereinafter also referred to as "CVD single crystal diamond") to achieve a long lifetime and thereby achieve better cost performance. Specifically, the present inventors considered management of an environment in a processing chamber in which the diamond tool and a workpiece are placed. Conventionally, the processing chamber typically has an atmosphere of air therein, and a contact point where the workpiece and the diamond tool are in contact with each other is often exposed to a cutting fluid jetted for the purpose of improving lubricity and cooling. However, such a conventional environmental management, even with various conditions variously controlled, has not solved the problem described above.

The present inventors have diligently studied why the conventional environmental management cannot solve the problem. As a result, it has been found that an amount by which the nano-polycrystalline diamond or the CVD single crystal diamond is worn during a cutting process sensitively varies with the temperature of the contact point of the tool and the workpiece and the oxygen concentration in the atmosphere near the contact point. Accordingly, the present inventors conducted further studies on this point.

As a result, the present inventors have found that when the contact point has higher temperature and the atmosphere near the contact point has higher oxygen concentration, reactive wear of the cutting edge of the diamond tool more easily occurs than mechanical wear thereof. Reactive wear is a phenomenon in which carbon atoms constituting diamond chemically bond with oxygen atoms in the atmosphere or oxygen atoms in the workpiece to become carbon dioxide or carbon monoxide, thereby wearing the diamond. Mechanical wear is a phenomenon in which diamond is worn due to a force caused as the diamond and the workpiece rub against each other.

Through a further study based on the above findings, the present inventors have found that when a diamond tool comprising nano-polycrystalline diamond or CVD single crystal diamond is used to process a workpiece, appropriately controlling the atmosphere near the contact point of the workpiece and the diamond tool and the diamond tool's temperature at the contact point allows significantly improved cost performance, and the present inventors have thus completed the present invention. Hereinafter, embodiments of the present invention will be enumerated and described.
[1] A method for processing a workpiece by using a diamond tool comprising nano-polycrystalline diamond or CVD single crystal diamond according to one aspect of the present disclosure is such that the nano-polycrystalline diamond comprises 10 ppm or more and 1000 ppm or less of nitrogen atoms and the vapor-phase synthesized single crystal diamond comprises 1 ppm or more and 100 ppm or less of nitrogen atoms, and in processing a workpiece the diamond tool has a temperature of 400°C or lower at a contact point of the workpiece and the diamond tool and a spatial region within a distance of 3 cm from the contact point has an oxygen concentration of 20% or less.
   The above processing method suppresses wear of a cutting edge of the diamond tool and thus extends the diamond tool's lifetime and hence improves its cost performance. Thus the above processing method can provide an excellently cost-effective method for processing a workpiece by using a diamond tool comprising nano-polycrystalline diamond or CVD single crystal diamond.
[2] The diamond tool is preferably a cutting tool. This allows the workpiece to be cut with even better cost performance.
[3] In the above processing method, the spatial region preferably contains an inert gas. This can further suppress wear of the cutting edge of the diamond tool and hence allows the workpiece to be cut with even better cost performance.
[4] In the above processing method, the inert gas is preferably at least one selected from the group consisting of helium, neon, argon, krypton, xenon, radon, nitrogen, and carbon dioxide. This can further suppress wear of the cutting edge of the diamond tool and hence allows the workpiece to be cut with even better cost performance.
[5] A machine tool according to one aspect of the present disclosure comprises: a processing chamber capable of accommodating a workpiece therein; a diamond tool disposed inside the processing chamber; a thermometer for measuring the temperature of a contact point of the workpiece accommodated in the processing chamber and the diamond tool; and an oxygen concentration meter for measuring an oxygen concentration at the contact point, the diamond tool comprising nano-polycrystalline diamond or vapor-phase synthesized single crystal diamond, the nano-polycrystalline diamond comprising 10 ppm or more and 1000 ppm or less of nitrogen atoms, the vapor-phase synthesized single crystal diamond comprising 1 ppm or more and 100 ppm or less of nitrogen atoms, the oxygen concentration meter being disposed at a position within 3 cm from the contact point, in processing the workpiece, a temperature, as measured by the thermometer, being controlled to 400°C or lower, an oxygen concentration, as measured by the oxygen concentration meter, being also controlled to have a value of 20% or less.
   The above machine tool when processing a workpiece suppresses wear of a cutting edge of the diamond tool and thus extends the diamond tool's lifetime and hence improves its cost performance. Thus the above machine tool can provide an excellently cost-effective machine tool employing a diamond tool comprising nano-polycrystalline diamond or CVD single crystal diamond.
[6] In the above machine tool, preferably, the oxygen concentration, as measured by the oxygen concentration meter, is controlled to have the value of 20% or less by introducing into the processing chamber a gaseous mixture composed of oxygen and nitrogen and having an oxygen concentration of 20% or less, carbon dioxide, or an inert gas. This further suppresses wear of the cutting edge of the diamond tool and hence achieves even better cost performance.
[7] A method for manufacturing a member according to one aspect of the present disclosure is a method for manufacturing a member by processing a workpiece by using a diamond tool comprising nano-polycrystalline diamond or vapor-phase synthesized single crystal diamond, the nano-polycrystalline diamond comprising 10 ppm or more and 1000 ppm or less of nitrogen atoms, the vapor-phase synthesized single crystal diamond comprising 1 ppm or more and 100 ppm or less of nitrogen atoms, in processing the workpiece, the diamond tool having a temperature of 400°C or lower at a contact point of the workpiece and the diamond tool, a spatial region within a distance of 3 cm from the contact point having an oxygen concentration of 20% or less.
   The above method for manufacturing a member suppresses wear of a cutting edge of the diamond tool and thus extends the diamond tool's lifetime and hence improves its cost performance. Thus the above method for manufacturing a member can provide an excellently cost-effective method for manufacturing a member by using a diamond tool comprising nano-polycrystalline diamond or CVD single crystal diamond.
[8] Preferably, the workpiece is composed of one or more types of materials selected from a hard brittle material, a nonferrous metal, a resin, and a reinforced plastic. The hard brittle material is composed of one or more types of materials selected from cemented carbide and ceramic. The nonferrous metal is composed of one or more types of materials selected from a copper alloy and an aluminum alloy. The resin is composed of one or more types of materials selected from acrylic and polycarbonate. The reinforced plastic is composed of one or more types of materials selected from carbon fiber reinforced plastic and glass fiber reinforced plastic. According to the method for manufacturing a member according to one aspect of the present disclosure, these materials can be cut and thus finished with excellent cost performance.

### [Detailed Description of Embodiments]

Hereinafter, a method for processing a workpiece by using a diamond tool according to the present embodiment will be described in detail with reference to the drawings. Note, however, that the present embodiment is not limited to these. In describing the figures, identical elements are identically denoted and will not be described redundantly. The figures are not necessarily scaled as described in the specification.

### <First embodiment: surface-machining a workpiece by an end mill>

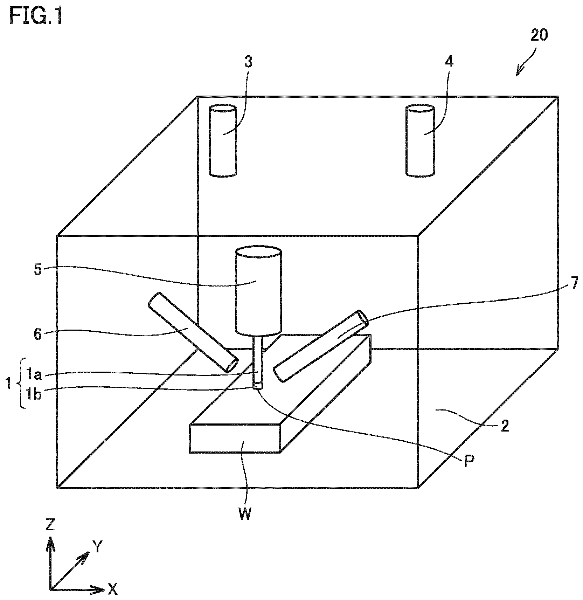

With reference to Fig. 1 will be described a method for processing a workpiece, a machine tool, and a method for manufacturing a member, by using a diamond tool according to one embodiment.

Fig. 1 is a schematic diagram for illustrating a method for processing a workpiece, a machine tool, and a method for manufacturing a member, by using a diamond tool according to one embodiment. In Fig. 1, a diamond tool 1 and a workpiece W are disposed in a processing chamber 2 of a machine tool 20.

While diamond tool 1 is preferably a cutting tool such as a turning tool or a milling tool, it may be a wear-resistant tool such as a die. While Fig. 1 shows diamond tool 1 as an end mill by way of example, diamond tool 1 is not limited thereto in type. Diamond tool 1 comprises a base body 1a and a cutting edge 1b. Base body 1a can be of any conventionally known material. Cutting edge 1b is composed of nano-polycrystalline diamond or CVD single crystal diamond. Cutting edge 1b may be composed of a base material made of a sintered material of diamond, cemented carbide or the like, and a coating of CVD single crystal diamond applied on a surface of the base material. Cutting edge 1b can be shaped to be a ball type, a radius type or the like, and a single cutting edge or two or more cutting edges are applicable.

When diamond tool 1 comprises nano-polycrystalline diamond, the nano-polycrystalline diamond comprises 10 ppm or more and 1000 ppm or less of nitrogen atoms. In contrast, when diamond tool 1 comprises CVD single crystal diamond, the CVD single crystal diamond comprises 1 ppm or more and 100 ppm or less of nitrogen atoms. Diamond tool 1 having such nano-polycrystalline diamond or CVD single crystal diamond is excellent in property, such as toughness and hardness, as a tool. In addition, through various experiments, it has been confirmed that in this case the present invention presents a remarkable effect. Note that nano-polycrystalline diamond and CVD single crystal diamond applicable to diamond tool 1 are not limited as described above.

Workpiece W is a workpiece to be processed by diamond tool 1. Workpiece W includes hard brittle materials such as cemented carbide and ceramic, nonferrous metals such as copper alloy and aluminum alloy, resins such as acrylic and polycarbonate, reinforced plastics such as carbon fiber reinforced plastic and glass fiber reinforced plastic, nonferrous materials, and the like.

As machine tool 20, a machining apparatus such as a machining center can be used. Machine tool 20 comprises processing chamber 2 to accommodate diamond tool 1 and workpiece W therein. Processing chamber 2 has a structure capable of maintaining high hermeticity and has a gas inlet 3 and a gas outlet 4 for adjusting an atmosphere inside the processing chamber. Gas inlet 3 can introduce any gas at a desired temperature and a desired humidity. Furthermore, a spindle 5 for fixing diamond tool 1 and a processing stage (not shown) for fixing workpiece W are disposed in processing chamber 2.

Furthermore, in processing chamber 2, there are provided a radiation thermometer 6 serving as a thermometer for measuring the temperature of a contact point P where workpiece W and cutting edge 1b of diamond tool 1 are in contact with each other, and an oxygen concentration meter 7 for measuring an oxygen concentration near contact point P. Oxygen concentration meter 7 is disposed to have an oxygen sensor portion positioned within a distance of 3 cm from contact point P in order to appropriately measure oxygen concentration in a spatial region within a distance of 3 cm from contact point P. It is preferable that oxygen concentration meter 7 be disposed to have the oxygen sensor portion located at a distance of 3 cm from contact point P.

In machine tool 20 shown in Fig. 1, diamond tool 1 manufactures a member by processing workpiece W as follows: Initially, diamond tool 1 is fixed to spindle 5, and workpiece W is placed on the processing stage by a vise or the like. Subsequently or simultaneously, a gas is introduced into processing chamber 2.

The introduced gas has a composition adjusted so that an oxygen concentration in a spatial region within a distance of 3 cm from contact point P is 20% or less. The gas introduced into processing chamber 2 through gas inlet 3 is controlled to fall within a desired range in temperature and humidity. The present embodiment does not employ a cutting fluid. In other words, there is no liquid present in the spatial region.

The spatial region preferably contains an inert gas. The inert gas includes at least one type selected from the group consisting of rare gases of helium, neon, argon, krypton, xenon and radon, nitrogen, and carbon dioxide. It goes without saying that the inert gas can include a gaseous mixture of these gases.

For example, when a gas present in the spatial region is a gaseous mixture having a composition composed of oxygen and nitrogen, a gas introduced through gas inlet 3 therefor may be a gaseous mixture having a composition composed of oxygen and nitrogen. In that case, the gaseous mixture preferably has an oxygen concentration of 20% or less. When a gas present in the spatial region is caused to contain carbon dioxide, dry ice may be disposed in the spatial region instead of introducing carbon dioxide, which is a gas.

In the processing chamber, workpiece W is processed under predetermined processing conditions to become a member. In processing or in manufacturing a member, for example, diamond tool 1 operates in the Z direction as spindle 5 moves, and diamond tool 1 rotates about the axis of spindle 5 as spindle 5 rotates. Further, workpiece W operates in the X direction and the Y direction as the processing stage operates. As a result, cutting edge 1b will move on a surface of workpiece W while rotating, and workpiece W has the surface cut.

Furthermore, in processing, the processing conditions indicated in Table 1 can be suitably implemented by the operation of spindle 5 and that of the processing stage. While Fig. 1 shows surface-machining, copying or other processing may be performed.

**Table 1**

| processing conditions | | | |
|---|---|---|---|
| spindle's rotational speed N (rpm) | feed rate Vf (mm/min.) | cutting depth ap (mm) | pick feed pf (mm) |
| 1,000-150,000 | 1-1,000 | 0.001-10 | 0.001-10 |

In the processing method and member manufacturing method described above, by appropriately selecting a gas introduced through gas inlet 3, an atmosphere in processing chamber 2 can be controlled, and accordingly, an oxygen concentration in the spatial region can be controlled to be 20% or less. Further, by controlling a rotational speed of spindle 5 without using a cutting fluid, the temperature of the diamond tool (or cutting edge) at contact point P can be controlled to 400°C or lower. Controlling the atmosphere near contact point P and the temperature of diamond tool 1 at contact point P, as described above, suppresses wear of cutting edge 1b. This allows diamond tool 1 to have an increased lifetime, and hence implements a method for processing workpiece W, a method for manufacturing a member, and a machine tool using the diamond tool, with excellent cost performance.

Further, in the present embodiment, preferably, an oxygen concentration of 10% or less is provided in the spatial region. This further suppresses wear of cutting edge 1b, and hence allows excellent cost performance.

### <Second Embodiment: Processing End Face of Workpiece by End Mill>

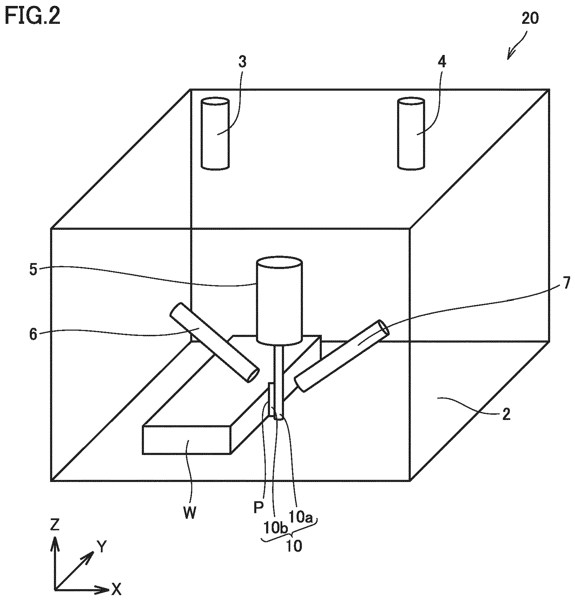

With reference to Fig. 2, a method for processing a workpiece, a machine tool, and a method for manufacturing a member, by using a diamond tool according to another embodiment, will be described.

Fig. 2 is a schematic diagram for illustrating a method for processing a workpiece, a machine tool, and a method for manufacturing a member, by using a diamond tool according to another embodiment. In Fig. 2, a diamond tool 10 and workpiece W are disposed in processing chamber 2 of machine tool 20.

While diamond tool 10 is preferably a cutting tool such as a turning tool and a milling tool, it may be a wear-resistant tool such as a die. While Fig. 2 shows diamond tool 10 as an end mill by way of example, diamond tool 10 is not limited thereto in type. Diamond tool 10 comprises a base body 10a and a cutting edge 10b. Base body 10a can be of any conventionally known material. Cutting edge 10b is composed of nano-polycrystalline diamond or CVD single crystal diamond. Cutting edge 10b may be composed of a base material made of a sintered material of diamond, cemented carbide or the like, and a coating of CVD single crystal diamond applied on a surface of the base material. Cutting edge 10b can be shaped to be a square type, and a single cutting edge or two or more cutting edges are applicable.

When diamond tool 10 comprises nano-polycrystalline diamond, the nano-polycrystalline diamond comprises 10 ppm or more and 1000 ppm or less of nitrogen atoms. In contrast, when diamond tool 10 comprises CVD single crystal diamond, the CVD single crystal diamond comprises 1 ppm or more and 100 ppm or less of nitrogen atoms. Diamond tool 10 comprising such nano-polycrystalline diamond or CVD single crystal diamond is excellent in property, such as toughness and hardness, as a tool. In addition, through various experiments, it has been confirmed that in this case the present invention presents a remarkable effect. Note that nano-polycrystalline diamond and CVD single crystal diamond applicable to diamond tool 10 are not limited as described above.

Workpiece W, machine tool 20, and the method for processing workpiece W are the same as those in the first embodiment, and accordingly, they will not be described repeatedly. In processing, the processing conditions indicated in Table 2 can be suitably implemented by the operation of spindle 5 and that of the processing stage.

**Table 2**

| processing conditions | | |
|---|---|---|
| spindle's rotational speed N (rpm) | feed rate Vf (mm/min.) | cutting depth ap (mm) |
| 1,000-150,000 | 10-1,000 | 0.001-5 |

Further, in the present embodiment, preferably, an oxygen concentration of 10% or less is provided in the spatial region. This further suppresses wear of cutting edge 1b, and hence allows excellent cost performance.

### Examples

Hereinafter, the present invention will more specifically be described with reference to examples although the present invention is not limited thereto.

### <Investigation 1: surface-machining by end mill>

### <<Example 1>>

Using a processing system and a machine tool as shown in Fig. 1, a method for processing a workpiece was performed under the conditions shown in Table 3. The workpiece was "AF1" made of carbide (super ultra fine grained carbide made by Sumitomo Electric Hardmetal) and the diamond tool had a cutting edge made of nano-polycrystalline diamond. A gaseous mixture of air and nitrogen was introduced through the gas inlet, with a mixing ratio controlled to control an oxygen concentration in the spatial region to be 20%. Furthermore, the spindle's rotational speed was controlled to maintain the diamond tool's temperature at the contact point to be 400°C. No cutting fluid was used.

After the processing was completed, by how much amount the diamond tool had worn a flank face adjacent to the cutting edge was measured. A result thereof is shown in Table 3. In Table 3, "NPD" means nano-polycrystalline diamond. "Introduced gas" means the type of gas introduced through the gas inlet, and "oxygen concentration" means the oxygen concentration in the spatial region, as measured with an oxygen concentration meter. "Contact point temperature" means the temperature of the diamond tool at the contact point.

### «Examples 2 to 10»

Except that the oxygen concentration in the spatial region was changed as shown in Table 3 by appropriately changing the mixing ratio of the gaseous mixture, the same method and machine tool as in Example 1 were used to perform the processing methods of Examples 2 to 5. Further, except that the temperature of the diamond tool at the contact point was changed as shown in Table 3 by appropriately changing the rotational speed of the spindle, the same method and machine tool as in Example 1 were used to perform the processing methods of Examples 6 to 10. After the processing was completed, by how much amount the diamond tool had worn a flank face adjacent to the cutting edge was measured. Each result is shown in Table 3.

### <<Comparative Examples 1 and 2>>

Except that the oxygen concentration in the spatial region and the temperature of the diamond tool at the contact point were changed as shown in Table 3 by appropriately changing the mixing ratio of the gaseous mixture and the rotational speed of the spindle, the same method and machine tool as in Example 1 were used to perform the processing methods of comparative examples 1 and 2. As had been done in Example 1, after the processing was completed, by how much amount the tool had worn a flank face adjacent to the cutting edge was measured. Each result is shown in Table 3.

**[Table 3]**

| | workpiece | material of cutting edge | shape of cutting edge | dimension of cutting edge (mm) | introduced gas | contact point temperature (°C) | oxygen concentration (%) | spindle's rotational speed N (rpm) | feed rate (mm/min.) | cutting depth (mm) | pick feed (mm) | processed distance (m) | width of wear of flank (µm) |
|---|---|---|---|---|---|---|---|---|---|---|---|---|---|
| ex. 1 | AF1 | NPD | radius, single cutting edge | Φ2.0 R0.2 | air + nitrogen | 400 | 20 | 80,000 | 600 | 0.01 | 1.0 | 10 | 79 |
| ex.2 | | | | | air + nitrogen | 400 | 10 | 80,000 | | | | | 37 |
| ex. 3 | | | | | air + nitrogen | 400 | 5 | 80,000 | | | | | 18 |
| ex. 4 | | | | | air + nitrogen | 400 | 2 | 80,000 | | | | | 13 |
| ex.5 | | | | | air + nitrogen | 400 | 0 | 80,000 | | | | | 10 |
| ex. 6 | | | | | air + nitrogen | 400 | 20 | 80,000 | | | | | 79 |
| ex. 7 | | | | | air + nitrogen | 300 | 20 | 60,000 | | | | | 53 |
| ex. 8 | | | | | air + nitrogen | 200 | 20 | 40,000 | | | | | 38 |
| ex.9 | | | | | air + nitrogen | 150 | 20 | 30,000 | | | | | 15 |
| ex. 10 | | | | | air + nitrogen | 100 | 20 | 20,000 | | | | | 8 |
| comp. ex. 1 | | | | | air + nitrogen | 450 | 20 | 90,000 | | | | | 85 |
| comp. ex. 2 | | | | | air + nitrogen | 400 | 25 | 80,000 | | | | | 100 |

As shown in Table 3, according to the processing methods of Examples 1 to 10, it has been confirmed that the diamond tool had the flank face worn by a small width. In contrast, comparative example 1 (i.e., a case where the diamond tool had a temperature of 450°C at the contact point) and comparative example 2 (i.e., a case where the spatial region had an oxygen concentration of 25%) each had a flank face worn by a large width.

### <Investigation 2: surface-machining by end mill>

Except that, of gases to be introduced, nitrogen was replaced with each of helium, neon, argon, krypton, xenon, radon, and carbon dioxide, the same processing methods as those in Examples 1-10 were performed. After the processing was completed, by how much amount the diamond tool had worn the flank face adjacent to the cutting edge was measured, and it has been confirmed that a behavior similar to those in Examples 1 to 10 was exhibited whichever one of the gases was used.

### <Investigation 3: processing end face by end mill>

### <<Examples 11 to 20>>

Using a processing system and a machine tool as shown in Fig. 2, a method for processing a workpiece was performed under the conditions shown in Table 4. The workpiece was "A390" made of an aluminum alloy (containing Si by about 17%) and the diamond tool had a cutting edge made of CVD single crystal diamond. The cutting edge had dimensions, of which a cutting edge length L was 15.0 mm. The oxygen concentration in the spatial region and the temperature of the diamond tool at the contact point were controlled in the same method as Example 1.

After the processing was completed, by how much amount the diamond tool had worn a flank face adjacent to the cutting edge was measured. A result thereof is shown in table 4. In Table 4, "CVDD" means nano-polycrystalline diamond.

### <<Comparative Examples 3 and 4>>

Except that the oxygen concentration in the spatial region and the temperature of the diamond tool at the contact point were changed as shown in Table 4 by appropriately changing the mixing ratio of the gaseous mixture and the rotational speed of the spindle, the same method and machine tool as in Example 11 were used to perform the processing methods of comparative examples 3 and 4. After the processing was completed, by how much amount the diamond tool had worn a flank face adjacent to the cutting edge was measured. Each result is shown in Table 4.

**[Table 4]**

| | workpiece | material of cutting edge | shape of cutting edge | dimension of cutting edge (mm) | introduced gas | contact point temper-ature (°C) | oxygen concentration (%) | spindle's rotational speed N (rpm) | feed rate (mm/min.) | cutting depth (mm) | processed distance (m) | width of wear flank (µm) |
|---|---|---|---|---|---|---|---|---|---|---|---|---|
| ex. 11 | A390 | CVDD | square, single cutting edge | Φ6.0 L15.0 | air + nitrogen | 400 | 20 | 10,000 | 1,000 | 0.5 | 50 | 40 |
| ex. 12 | | | | | air + nitrogen | 400 | 10 | 10,000 | | | | 21 |
| ex. 13 | | | | | air + nitrogen | 400 | 5 | 10,000 | | | | 12 |
| ex. 14 | | | | | air + nitrogen | 400 | 2 | 10,000 | | | | 5 |
| ex. 15 | | | | | air + nitrogen | 400 | 0 | 10,000 | | | | 2 |
| ex. 16 | | | | | air + nitrogen | 400 | 20 | 10,000 | | | | 40 |
| ex. 17 | | | | | air + nitrogen | 300 | 20 | 7,500 | | | | 32 |
| ex. 18 | | | | | air + nitrogen | 200 | 20 | 5,000 | | | | 25 |
| ex. 19 | | | | | air + nitrogen | 150 | 20 | 3,750 | | | | 11 |
| ex. 20 | | | | | air + nitrogen | 100 | 20 | 2,500 | | | | 4 |
| comp. ex. 3 | | | | | air + nitrogen | 450 | 20 | 11,250 | | | | 47 |
| comp. ex. 4 | | | | | air + nitrogen | 400 | 25 | 10,000 | | | | 62 |

As shown in Table 4, according to the processing methods of Examples 11 to 20, it has been confirmed that the diamond tool had the flank face worn by a small width. In contrast, comparative example 3 (i.e., a case where the diamond tool had a temperature of 450°C at the contact point) and comparative example 4 (i.e., a case where the spatial region had an oxygen concentration of 25%) each had a flank face worn by a large width.

### <Investigation 4: processing end face by end mill>

Except that, of gases to be introduced, nitrogen was replaced with each of helium, neon, argon, krypton, xenon, radon, and carbon dioxide, the same processing method as that in Example 11 was performed. For each case, by how much amount the diamond tool had the flank face worn was measured, and it has been confirmed that a behavior similar to that in Example 11 was exhibited whichever one of the gases was used.

### <Investigation 5: Investigation of materials for workpiece>

According to the present invention, it has been confirmed through an experiment that wear of the diamond tool is suppressed regardless of whatever material may be used to form the workpiece. That is, even when the workpiece was formed of hard brittle materials other than cemented carbide (ceramic), nonferrous metals (copper alloy, aluminum alloy, etc.), resins (acrylic, polycarbonate, etc.), reinforced plastics (carbon fiber reinforced plastic, glass fiber reinforced plastic, etc.), or others such as nonferrous materials, wear of the diamond tool was suppressed similarly as in a case where the workpiece was formed of cemented carbide.

It should be understood that the embodiment and example disclosed herein have been described for the purpose of illustration only and in a non-restrictive manner in any respect. The scope of the present invention is defined by the terms of the claims, rather than the embodiments and examples described above, and is intended to include any modifications within the meaning and scope equivalent to the terms of the claims.

### REFERENCE SIGNS LIST

1, 10: diamond tool; 1a, 10a: base body; 1b, 10b: cutting edge; 2: processing chamber; 3: gas inlet; 4: gas outlet; 5: spindle; 6: radiation thermometer; 7: oxygen concentration meter; W: workpiece; P: contact point.

## Claims

1. A method for processing a workpiece by using a diamond tool comprising nano-polycrystalline diamond or vapor-phase synthesized single crystal diamond,
the nano-polycrystalline diamond comprising 10 ppm or more and 1000 ppm or less of nitrogen atoms, the vapor-phase synthesized single crystal diamond comprising 1 ppm or more and 100 ppm or less of nitrogen atoms,
in processing the workpiece,
the diamond tool having a temperature of 400°C or lower at a contact point of the workpiece and the diamond tool,
a spatial region within a distance of 3 cm from the contact point having an oxygen concentration of 20% or less.

2. The method for processing a workpiece by using a diamond tool comprising nano-polycrystalline diamond or vapor-phase synthesized single crystal diamond according to claim 1, wherein the diamond tool is a cutting tool.

3. The method for processing a workpiece by using a diamond tool comprising nano-polycrystalline diamond or vapor-phase synthesized single crystal diamond according to claim 1 or 2, wherein the spatial region contains an inert gas.

4. The method for processing a workpiece by using a diamond tool comprising nano-polycrystalline diamond or vapor-phase synthesized single crystal diamond according to claim 3, wherein the inert gas is at least one selected from the group consisting of helium, neon, argon, krypton, xenon, radon, nitrogen, and carbon dioxide.

5. A machine tool comprising:
a processing chamber capable of accommodating a workpiece therein;
a diamond tool disposed inside the processing chamber;
a thermometer for measuring a temperature of a contact point of the workpiece accommodated in the processing chamber and the diamond tool; and
an oxygen concentration meter for measuring an oxygen concentration at the contact point,
the diamond tool comprising nano-polycrystalline diamond or vapor-phase synthesized single crystal diamond,
the nano-polycrystalline diamond comprising 10 ppm or more and 1000 ppm or less of nitrogen atoms, the vapor-phase synthesized single crystal diamond comprising 1 ppm or more and 100 ppm or less of nitrogen atoms,
the oxygen concentration meter being disposed at a position within 3 cm from the contact point,
in processing the workpiece, a temperature, as measured by the thermometer, being controlled to 400°C or lower, an oxygen concentration, as measured by the oxygen concentration meter, being also controlled to have a value of 20% or less.

6. The machine tool according to claim 5, wherein the oxygen concentration, as measured by the oxygen concentration meter, is controlled to have the value of 20% or less by introducing into the processing chamber a gaseous mixture composed of oxygen and nitrogen and having an oxygen concentration of 20% or less, carbon dioxide, or an inert gas.

7. A method for manufacturing a member by processing a workpiece by using a diamond tool comprising nano-polycrystalline diamond or vapor-phase synthesized single crystal diamond,
the nano-polycrystalline diamond comprising 10 ppm or more and 1000 ppm or less of nitrogen atoms, the vapor-phase synthesized single crystal diamond comprising 1 ppm or more and 100 ppm or less of nitrogen atoms,
in processing the workpiece,
the diamond tool having a temperature of 400°C or lower at a contact point of the workpiece and the diamond tool,
a spatial region within a distance of 3 cm from the contact point having an oxygen concentration of 20% or less.

8. The method for manufacturing a member according to claim 7, wherein
the workpiece is composed of one or more types of materials selected from a hard brittle material, a nonferrous metal, a resin, and a reinforced plastic,
the hard brittle material is composed of one or more types of materials selected from cemented carbide and ceramic,
the nonferrous metal is composed of one or more types of materials selected from a copper alloy and an aluminum alloy,
the resin is composed of one or more types of materials selected from acrylic and polycarbonate, and
the reinforced plastic is composed of one or more types of materials selected from carbon fiber reinforced plastic and glass fiber reinforced plastic.
